# EUROPÄISCHE PATENTSCHRIFT

(11) **EP 2 624 322 B1**
(45) Veröffentlichungstag und Bekanntmachung des Hinweises auf die Patenterteilung: **23.07.2014**
(21) Anmeldenummer: 12000596.2
(22) Anmeldetag: 31.01.2012
(51) Int. Cl.: H01L 41/313

(54) **Verfahren und Vorrichtung zur Herstellung von Piezowandlern**
Method and device for producing piezo transducers
Procédé et dispositif destinés à la fabrication de piézoconvertisseurs

(43) Veröffentlichungstag der Anmeldung: 07.08.2013
(73) Patentinhaber: FESTO AG & Co. KG, 73734 Esslingen (DE)
(72) Erfinder: Schauz, Stephan, 73340 Amstetten (DE); Pein, Carsten, 71394 Kernen (DE)
(74) Vertreter: Abel, Martin

(56) Entgegenhaltungen:
- WO-A2-02/05391
- JP-A- 2007 267 575
- JP-A- 2008 131 059
- US-A1- 2006 143 898

## Beschreibung

Die Erfindung betrifft ein Verfahren zur Herstellung von Piezowandlern, die jeweils in einer Schichtungsrichtung aufeinandergeschichtete Substrate in Form eines magnetischen Trägersubstrates und eines piezoelektrisch aktivierbaren Piezosubstrates aufweisen, die mittels eines zwischen ihnen befindlichen Klebstoffes aneinander befestigt sind, wobei die beiden Substrate nach zuvor auf mindestens einem der Substrate erfolgter Applikation von Klebstoff unter Bildung einer Substratbaugruppe aufeinandergeschichtet und in der Schichtungsrichtung miteinander verspannt werden.

Die Erfindung betrifft ferner eine Vorrichtung zur Herstellung von Piezowandlern, die jeweils in einer Schichtungsrichtung aufeinandergeschichtete Substrate in Form eines magnetischen Trägersubstrates und eines piezoelektrisch aktivierbaren Piezosubstrates aufweisen, die mittels eines zwischen ihnen befindlichen Klebstoffes aneinander befestigt sind, mit mindestens einer Spanneinrichtung, durch die die beiden nach vorheriger Applikation des Klebstoffes zu einer Substratbaugruppe aufeinandergeschichteten Substrate in der Schichtungsrichtung miteinander verspannbar sind.

Piezowandler werden häufig als Aktoren in Ventilen eingesetzt, um Fluidströmungen zu steuern. Neben der Bauart sogenannter Stapeltranslatoren kommen insbesondere als Biegewandler ausgebildete Piezowandler zum Einsatz. Vor allem im Zusammenhang mit 2/2-Wegeventilen werden piezoelektrische Biegewandler vom monomorphen Typ eingesetzt, die ein passives Trägersubstrat und ein darauf geschichtetes Piezosubstrat enthalten, wobei das Piezosubstrat in der Regel aus einem streifenförmigen oder plattenförmigen Piezokörper und zwei den Piezokörper flankierenden Elektroden besteht. Das oftmals aus einem ferromagnetischen Stahlblech bestehende Trägersubstrat und das Piezosubstrat sind durch eine zwischen ihnen applizierte Schicht aus Klebstoff fest miteinander verbunden. Aufgrund der Oberflächenrauhigkeit des Trägersubstrates ergeben sich trotz des Klebstoffes unzählige Kontaktpunkte zwischen dem Trägersubstrat und der benachbarten Elektrode des Piezosubstrates, so dass eine elektrisch leitende Verbindung vorliegt, was es ermöglicht, das Stahlblech zur elektrischen Kontaktierung der benachbarten Elektrode zu nutzen.

Laut nicht schriftlich dokumentierten, internen Kenntnissen der Anmelderin werden Piezowandler der zuvor geschilderten Art bisher dadurch gefertigt, dass zunächst eine separate Fertigung des Trägersubstrates und des Piezosubstrates stattfindet, worauf diese beiden Substrate nach vorheriger Applikation eines Klebstoffes zu einer Substratbaugruppe aufeinandergeschichtet und dann mittels einer mechanischen Spanneinrichtung so lange miteinander verspannt werden, bis der Klebstoff die notwendige Verbindungsfestigkeit erreicht hat. Wichtig ist dabei die Einhaltung einer vorbestimmten Spannkraft, um einerseits die Substrate nicht zu beschädigen und andererseits eine optimale Verteilung des Klebstoffes zu gewährleisten. Dafür bedarf es konstruktiv aufwendiger Spanneinrichtungen, die eine kraftgeregelte Betriebsweise ermöglichen. Solche Spanneinrichtungen sind jedoch relativ teuer und ihr Einsatz ist sehr zeitraubend. Insbesondere für einen Serienprozess zur vielfachen Herstellung von Piezowandlern scheinen solche Vorrichtungen und Verfahrensweisen daher eher weniger geeignet.

Der Erfindung liegt die Aufgabe zugrunde, Maßnahmen zu treffen, die eine präzise und dennoch kostengünstige und rationelle Fertigung von Piezowandlern zulassen.

Zur Lösung dieser Aufgabe ist bei einem Verfahren der eingangs genannten Art vorgesehen, dass zum Verspannen der beiden Substrate das Piezosubstrat abgestützt und das Trägersubstrat durch elektromagnetisch erzeugte Magnetkraft an das abgestützte Piezosubstrat angepresst wird.

Die Aufgabe wird ferner bei einer Vorrichtung der eingangs genannten Art dadurch gelöst, dass die Spanneinrichtung als elektromagnetische Magnetspanneinrichtung ausgebildet ist, die eine Abstützfläche zur Abstützung des Piezosubstrates der zu verspannenden Substratbaugruppe aufweist und durch die elektromagnetisch eine Magnetkraft erzeugbar ist, mittels der das Trägersubstrat der an der Abstützfläche abgestützten Substratbaugruppe in Richtung der Abstützfläche derart beaufschlagbar ist, dass es an das von der Abstützfläche abgestützte Piezosubstrat angepresst wird.

Sowohl dem Verfahren als auch der Vorrichtung liegt der Kerngedanke zugrunde, die zu verspannenden Substrate der letztlich den Piezowandler bildenden Substratbaugruppe nicht mechanisch zwischen Spannbacken einer schraubstockartigen Spannvorrichtung einzuspannen, sondern allein durch elektromagnetisch erzeugte Magnetkraft miteinander zu verpressen. Bei der Ausübung des Verfahrens wird die Substratbaugruppe mit ihrem Piezosubstrat ortsfest abgestützt und das Trägersubstrat aufgrund seiner magnetischen Eigenschaften unmittelbar selbst ohne zusätzliches Spannelement in Richtung des Piezosubstrates beaufschlagt, so dass die beiden Substrate aufgrund der Abstützung des Piezosubstrates miteinander verpresst werden und der zwischen ihnen befindliche Klebstoff sich optimal verteilen kann. Da das Trägersubstrat hierbei keine unmittelbare mechanische Kraftbeaufschlagung erfährt, ergibt sich ein sehr schonender Spannvorgang mit einer gleichmäßigen Kraftverteilung.

Die erfindungsgemäße Vorrichtung verfügt zum Verspannen der beiden Substrate über eine elektromagnetische Magnetspanneinrichtung, die eine Abstützfläche aufweist, an der die Substratbaugruppe mit ihrem Piezosubstrat während des Spannvorganges abstützbar ist, wobei die Magnetspanneinrichtung eine Magnetkraft erzeugen kann, durch die das magnetische Trägersubstrat in Richtung der Abstützfläche beaufschlagbar ist, so dass es an das seinerseits an der Abstützfläche abgestützte Piezosubstrat angepresst wird.

Durch die Nutzung der Magnetkraft zum Zusammenspannen der beiden Substrate ergibt sich der weitere Vorteil, dass unabhängig von den Dickentoleranzen der beiden Substrate und insbesondere des Trägersubstrates stets die gleiche Spannkraft hervorrufbar ist, und zwar auch ohne eine aufwendige Kraftregelung. Sowohl beim Verfahren als auch bei der Vorrichtung bestehen keine besonderen Anforderungen an die magnetischen Eigenschaften des Trägersubstrates, so dass insbesondere ein kostengünstiges ferromagnetisches Material nutzbar ist, insbesondere ein gewalztes Stahlblech. Durch das elektromagnetische Verspannen der Substratbaugruppe eröffnet sich schließlich auch die vorteilhafte Möglichkeit für eine rationelle Serienfertigung von Piezowandlern, insbesondere von piezoelektrischen Biegewandlern.

Vorteilhafte Weiterbildungen der Erfindung gehen aus den Unteransprüchen hervor.

In Verbindung mit dem erfindungsgemäßen Verfahren wird zweckmäßigerweise eine ziehend wirkende Magnetkraft an das Piezosubstrat angelegt. Bei der Vorrichtung lässt sich dies besonders einfach dadurch realisieren, dass die Magnetspanneinrichtung mit einer Elektromagneteinrichtung ausgestattet wird, die auf der der Abstützfläche abgewandten Seite platziert ist, so dass die Abstützfläche zwischen der Elektromagneteinrichtung und dem Trägersubstrat der zu verspannenden Substratbaugruppe zu liegen kommt und folglich das Trägersubstrat durch die von der Elektromagneteinrichtung erzeugte Magnetkraft in Richtung zu der Abstützfläche hin gezogen wird, wodurch das Piezosubstrat zwischen der Abstützfläche und dem Trägersubstrat eingespannt wird. Hierbei wird die ziehend wirkende Magnetkraft insbesondere unmittelbar durch das Piezosubstrat hindurch in das Trägersubstrat eingeleitet.

Bei dem Verfahren kann das Verspannen der beiden Substrate in vorteilhafter Weise während eines Transportvorganges der Substratbaugruppe stattfinden, und zwar insbesondere während eines Transportes von einer Fügestation zu einer Abgabestation. In der Fügestation werden die Substrate unter Applikation des Klebstoffes zu der Substratbaugruppe zusammengefasst, während sie in der Abgabestation, insbesondere bereits als fertige Piezowandler, abtransportiert werden können.

In Verbindung mit dem vorgenannten Transportvorgang kann die Magnetspanneinrichtung der zur Herstellung von Piezowandlern nutzbaren Vorrichtung Bestandteil einer Transporteinrichtung sein, so dass die die Substratbaugruppe magnetisch festhaltende Magnetspanneinrichtung zwischen verschiedenen Arbeitsstationen bewegbar ist, wobei der Zeitraum des Transportvorganges in vorteilhafter Weise zum stoffschlüssigen Zusammenfügen der Substrate des Piezowandlers nutzbar ist. Auf diese Weise ist eine sehr zeitsparende Fertigung möglich.

Bei der Herstellung der Piezowandler kann zur Realisierung der Substratbaugruppen zur Bildung der Trägersubstrate auf ein großflächiges, zum Beispiel bandförmiges Ausgangssubstrat zurückgegriffen werden, das nebeneinander mit Piezosubstraten bestückt wird und das nach dem Verkleben der einzelnen Substratpaarungen durchtrennt wird, um eine Vereinzelung zu erzielen. Das Zusammenfügen der Piezowandler kann jedoch auch auf der Grundlage einzelner Substratbaugruppen stattfinden, denen bereits vorkonfektionierte Trägersubstrate zugrundeliegen.

Eine für den Transport der Substratbaugruppen nutzbare Transporteinrichtung der erfindungsgemäßen Vorrichtung kann über eine Mehrfachausstattung an Magnetspanneinrichtungen verfügen, um simultane Transportvorgänge mehrerer Substratbaugruppen zwischen verschiedenen Arbeitsstationen zu ermöglichen. Beispielsweise kann die Transporteinrichtung einen endlos umlaufenden Transportstrang enthalten, an dem aufeinanderfolgend mehrere Magnetspanneinrichtungen angeordnet sind, die eine kontinuierliche Umlaufbewegung ausführen. Alternativ kann die Transporteinrichtung auch zur Ausführung sogenannter "Pick-and-place"-Abläufe ausgestattet sein, wobei eine oder mehrere Magnetspanneinrichtungen alternierend zwischen zwei Arbeitsstationen hin und her bewegt werden.

Bei der Ausführung des Verfahrens erfolgt das Verpressen der aufeinandergeschichteten Substrate zweckmäßigerweise unter gleichzeitiger Wärmezufuhr. Die Vorrichtung ist zweckmäßigerweise mit Heizmitteln ausgestattet, die es ermöglichen, die jeweils an einer Magnetspanneinrichtung gehaltene Stapelbaugruppe aufzuheizen. Besonders vorteilhaft werden Heizmittel angesehen, die pro Magnetspanneinrichtung eine eigene Heizeinrichtung enthalten, wobei diese Heizeinrichtung der betreffenden Magnetspanneinrichtung unmittelbar zugeordnet ist und insbesondere als Baueinheit mit der Magnetspanneinrichtung ausgebildet ist. Letzteres schafft den Vorteil, dass bei einer Verlagerung der Magnetspanneinrichtung zum Zwecke eines Umsetzens der festgehaltenen Stapelbaugruppe die Heizeinrichtung mitbewegt wird und die erzeugte Heizenergie in unmittelbarer Nähe des Entstehungsortes ohne nennenswerte Wärmeverluste in die Komponenten der Substratbaugruppe eingeleitet wird. Das Beheizen begünstigt das Aushärten der Klebeverbindung zwischen dem Trägersubstrat und dem Piezosubstrat, da vorzugsweise ein thermisch aushärtender Klebstoff verwendet wird. Durch den Wärmeeintrag wird zudem die Viskosität des Klebstoffes abgesenkt, so dass er sich in Verbindung mit dem durch die gegeneinander gespannten Strukturen auf ihn ausgeübten Druck optimal großflächig über die gesamte Fügefläche hinweg verteilt.

Das Aufheizen der Substratbaugruppe während des Verklebens ihrer Substrate bringt auch Vorteile für nachgeschaltete Herstellungsschritte mit sich. Durch die erhöhte Temperatur ist beim anschließenden Anlöten oder Ankleben der zur Bestromung des Piezowandlers erforderlichen Kontakte nur noch ein geringer Wärmeenergieeintrag notwendig.

Selbst wenn bei einer Vorrichtung zur Herstellung von Piezowandlern die Magnetspanneinrichtungen mit individuellen Heizeinrichtungen ausgestattet sind, können zusätzliche Heizmaßnahmen oder Heizstrecken vorhanden sein, die gleichzeitig wirksam sind oder die Heizwirkung verlängern, nachdem die Substratbaugruppen nicht mehr in einer Magnetspanneinrichtung gespannt sind.

Die Heizstrecke der mit Heizeinrichtungen ausgestatteten elektromagnetischen Magnetspanneinrichtungen muss im Übrigen nicht zwingend der Aushärtezeit des Klebstoffes entsprechen, da schon nach einer kurzen Anhärtung bereits ein ausreichender Stoffschluss vorhanden ist, um die sich anschließenden Prozessschritte zu ermöglichen, beispielsweise das Kontaktieren elektrischer Leiter oder ein Vereinzeln der Stapelbaugruppen.

Durch die elektromagnetischen Spannvorgänge kann sich in dem Trägersubstrat je nach Material eine dauerhafte Magnetisierung ausbilden. Sofern dies bei der späteren Verwendung des Piezowandlers unerwünscht ist, kann durch einen sich an den Verpressvorgang anschließenden Prozessschritt die Polarisierung aufgehoben werden, beispielsweise durch Anlegen eines der Magnetspanneinrichtung entgegengesetzten Magnetfeldes.

Nachfolgend wird die Erfindung anhand der beiliegenden Zeichnung näher erläutert. Im Einzelnen zeigen:
- Figur 1: einen Längsschnitt durch einen als Biegewandler ausgestalteten Piezowandler, wie er erfindungsgemäß herstellbar ist, in einem stark vergrößerten Maßstab,
- Figur 2: eine bevorzugte Ausgestaltung einer Vorrichtung zur Herstellung von Piezowandlern, die zur Durchführung des erfindungsgemäßen Verfahrens geeignet ist, wobei Einzelheiten separat vergrößert illustriert sind, das Ganze im Längsschnitt gemäß Schnittlinie II-II aus Figur 3,
- Figur 3: die Vorrichtung aus Figur 2 in einer Draufsicht,
- Figur 4: die Vorrichtung aus Figuren 2 und 3 in einer perspektivischen Ansicht,
- Figur 5: eine alternative erfindungsgemäße Vorrichtung zur Herstellung von Piezowandlern in einer perspektivischen Darstellung, mit der ebenfalls eine Variante des erfindungsgemäßen Verfahrens ausführbar ist, und
- Figur 6: eine Seitenansicht der Vorrichtung aus Figur 5, in der eine Magnetspanneinrichtung separat nochmals in vergrößertem Maßstab illustriert ist.

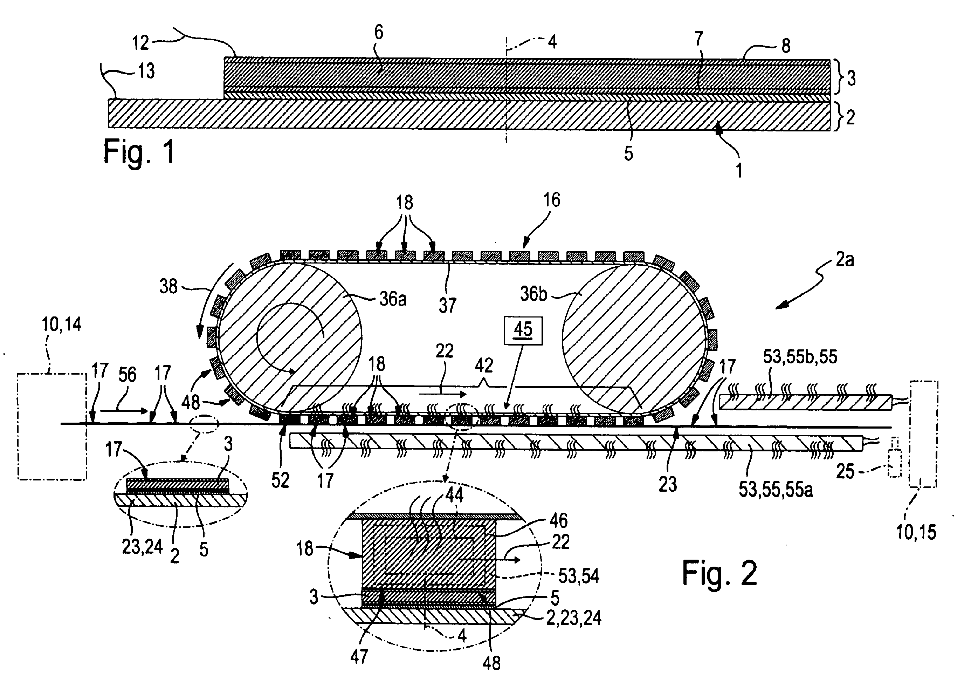

Die Figur 1 illustriert im Längsschnitt einen Piezowandler 1, der unter Verwendung der in den übrigen Figuren abgebildeten Herstellungsvorrichtungen 2a und 2b herstellbar ist. Es handelt sich hier um eine Ausgestaltung als piezoelektrischer Biegewandler, ohne dass sich die Erfindung auf diese Art von Piezowandlern 1 beschränken soll.

Der Piezowandler 1 hat einen Schichtaufbau mit einem ersten Substrat in Form eines Trägersubstrates 2 und einem zweiten Substrat in Form eines Piezosubstrates 3. Die beiden Substrate 2, 3 haben jeweils eine flächenhafte Ausdehnung und sind in einer zu ihren Ausdehnungsebenen rechtwinkeligen Schichtungsrichtung 4 aufeinandergelegt und mittels eines zwischen ihnen insbesondere schichtartig verteilt angeordneten Klebstoffes 5 stoffschlüssig miteinander verbunden.

Das Trägersubstrat 2 hat magnetische und insbesondere ferromagnetische Eigenschaften. Beim Ausführungsbeispiel besteht es aus Stahl.

Das Piezosubstrat 3 hat als Kern einen aus einem Piezomaterial bestehenden Piezokörper 6. Das Piezomaterial ist vorzugsweise eine Piezokeramik. In der Schichtungsrichtung 4 beidseits ist der Piezokörper 6 von je einer flächigen Elektrode 7, 8 flankiert, wobei die zwischen ihm und dem Trägersubstrat 2 angeordnete Elektrode 7 als innere Elektrode 7 und die an der dem Trägersubstrat 2 abgewandten Außenseite angeordnete Elektrode 8 als äußere Elektrode 8 bezeichnet sei. Die Elektroden 7, 8 sind durch beliebige geeignete Maßnahmen auf dem Piezokörper 6 befestigt, beispielsweise durch Metallabscheidung.

Die beiden Substrate 2, 3 sind vorzugsweise streifenförmig gestaltet. Exemplarisch hat das Piezosubstrat 3 eine etwas geringere Länge als das Trägersubstrat 2, so dass Letzteres an einer Stirnseite über das Piezosubstrat 3 hinausragt. Das Trägersubstrat 2 ist zweckmäßigerweise elektrisch leitend. Die Schicht aus Klebstoff 5 ist derart dünn, dass aufgrund der vorhandenen Oberflächenrauhigkeit des Trägersubstrates 2 eine Vielzahl punktueller, elektrisch leitender Verbindungen zwischen dem Trägersubstrat 2 und der inneren Elektrode 7 vorliegt.

Die beiden Elektroden 7, 8 sind mittels wegführender elektrischer Leiter 12, 13 elektrisch kontaktiert. Die elektrischen Leiter 12, 13, beispielsweise Drähte, sind elektrisch leitend angelötet oder angeklebt. Der eine elektrische Leiter 12 ist direkt mit der äußeren Elektrode 8 kontaktiert. Der andere elektrische Leiter 13 ist an dem über den Piezokörper 6 hinausragenden Endabschnitt des elektrisch leitenden Trägersubstrates 2 kontaktiert, wobei die elektrische Verbindung zur inneren Elektrode 7 über den elektrisch leitenden Kontakt im Bereich der Klebeverbindung stattfindet.

Bei einem typischen Einsatz wird der Piezowandler 1 im Bereich seines die elektrischen Leiter 12, 13 aufweisenden Endabschnittes fixiert und über die elektrischen Leiter 12, 13 mit einer variablen elektrischen Ansteuerspannung beaufschlagt. Das Anlegen der Spannung ruft in dem Piezokörper 6 aufgrund des reziproken piezoelektrischen Effektes eine Längenänderung hervor, die das passive Trägersubstrat 2 nicht mitmacht, so dass sich der Piezowandler 1 insgesamt durchbiegt. Dieses Verhalten kann beispielsweise genutzt werden, um ein zur Steuerung von Fluidströmen dienendes Ventil zu betätigen.

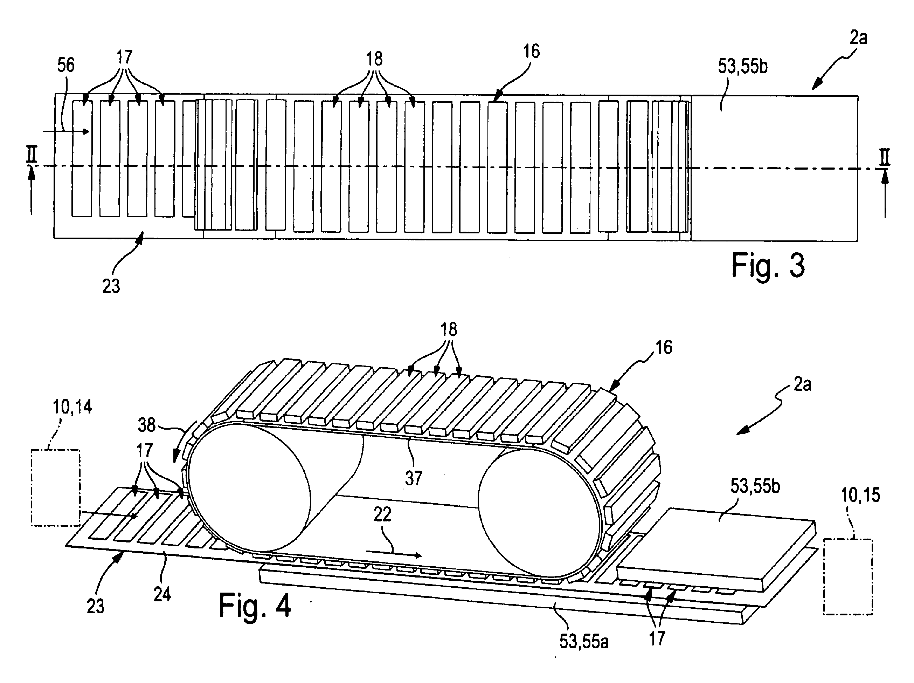

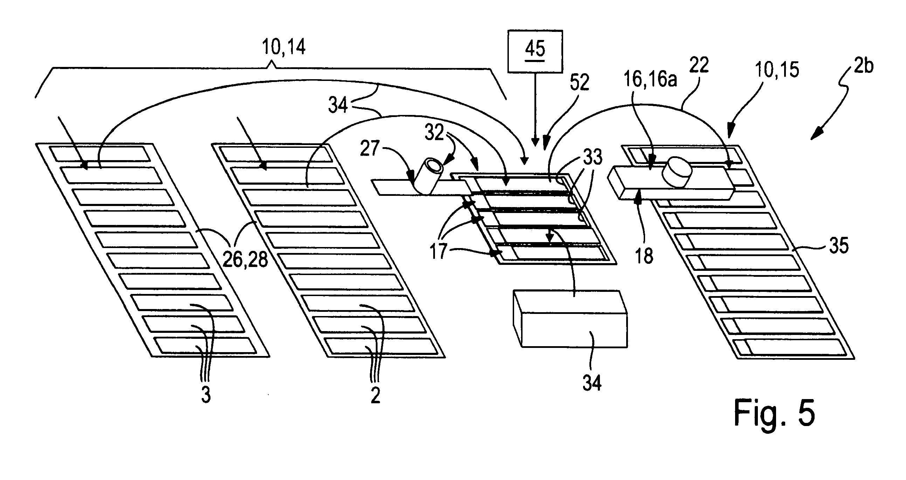

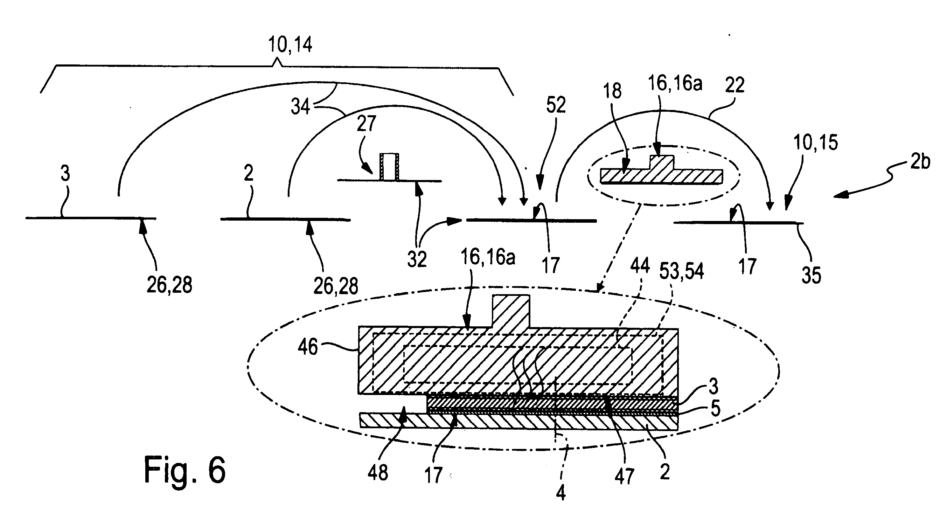

Die beiden zum einen in Figuren 2 bis 4 und zum anderen in Figuren 5 und 6 abgebildeten Herstellungsvorrichtungen 2a, 2b sind ausgebildet, um den in Figur 1 illustrierten Piezowandler 1 herzustellen. In der Zeichnung sind allerdings nur erfindungsrelevante Vorrichtungskomponenten illustriert.

Jede Herstellungsvorrichtung 2a, 2b hat zweckmäßigerweise eine Fügestation 14 und eine Abgabestation 15. Dazwischen befindet sich eine Transporteinrichtung 16.

In der Fügestation 14 werden mit Ausnahme der elektrischen Leiter 12, 13 die oben geschilderten Komponenten des Piezowandlers 1 zu einer Substratbaugruppe 17 zusammengesetzt. Die Fügestation 14 ist für eine Serienfertigung ausgelegt und ermöglicht es, eine Vielzahl von Substratbaugruppen 17 in zeitlicher Aufeinanderfolge zusammenzustellen. Jede Substratbaugruppe 17 besteht aus einem Trägersubstrat 2, einem auf dem Trägersubstrat 2 in der gewünschten Ausrichtung platzierten Piezosubstrat 3 und einem in dem Fügebereich zwischen dem Trägersubstrat 2 und dem Piezosubstrat 3 applizierten Klebstoff 5.

Die derart zusammengestellten Substratbaugruppen 17 werden mittels der Transporteinrichtung 16 nacheinander aus der Fügestation 14 in die Abgabestation 15 transportiert. Von dort werden sie ihrer weiteren Bestimmung zugeleitet, insbesondere zu einer Kontaktierungsstation, in der die elektrischen Leiter 12, 13 angelötet oder angeklebt werden.

Zumindest während ihres Transports mittels der Transporteinrichtung 16 werden die zuvor zu einer Substratbaugruppe 17 zusammengesetzten Substrate 2, 3 unter Aufbringung einer Spannkraft in der Schichtungsrichtung 4 fest zusammengepresst und dabei mittels des zwischen ihnen angeordneten Klebstoffes 5 fest miteinander verbunden. Eine Besonderheit besteht darin, dass die Spannkraft ausschließlich eine elektromagnetisch erzeugte Magnetkraft ist. Dadurch werden die Substrate 2, 3 besonders schonend und mit exakt definierbarer Kraft zusammengepresst.

Die Transporteinrichtung 16 enthält mindestens eine elektromagnetisch arbeitende Magnetspanneinrichtung 18, die in der Lage ist, bei Anlegen einer geeigneten elektrischen Betätigungsspannung ein Magnetfeld zu erzeugen, durch das ein magnetischer Körper und somit das Trägersubstrat 2 magnetisch anziehbar ist. Jede Magnetspanneinrichtung 18 ist dafür geeignet, eine Substratbaugruppe 17 lösbar festzuhalten und dabei gleichzeitig die Substrate 2, 3 zur Ausbildung der gewünschten Klebeverbindung fest miteinander zu verpressen. Dieser insgesamt auch als Spannzustand bezeichenbare Zustand des Verpressens kann vorteilhafterweise während einer durch einen Pfeil angedeuteten Transportbewegung 22 aufrechterhalten werden, im Rahmen derer die Magnetspanneinrichtung 18 aus dem Bereich der Fügestation 14 in den Bereich der Abgabestation 15 verlagert wird. Die beiden Substrate jeder Substratbaugruppe 17 können also in zeitsparender Weise während ihres Transportes aus der Fügestation 14 in die Abgabestation 15 zwecks Verklebung miteinander verspannt werden.

In der Fügestation 14 werden die Substratbaugruppen 17 nacheinander zusammengesetzt. Jede Substratbaugruppe 17 enthält, wie schon erwähnt, ein die Basis bildendes, über magnetische Eigenschaften verfügendes Trägersubstrat 2, ein auf das Trägersubstrat 2 in der Schichtungsrichtung 4 aufgelegtes Piezosubstrat 3 und einen zwischen den beiden Substraten 2, 3 applizierten Klebstoff 5.

Beim Ausführungsbeispiel der Figuren 2 bis 4 werden die Substratbaugruppen 17 nicht als individuelle Baugruppen zwischen der Fügestation 14 und der Abgabestation 15 umgesetzt, sondern in der Form eines Substratstranges 23. Dieser Substratstrang 23 hat ein bevorzugt bandförmiges oder streifenförmiges Ausgangssubstrat 24, dessen struktureller Aufbau demjenigen des gewünschten Trägersubstrates 2 entspricht und das zur Bildung der einzelnen Trägersubstrate 2 lediglich noch durch Trennvorgänge abgelängt werden muss. In der Fügestation 14 werden auf dem Ausgangssubstrat 24 in dessen Längsrichtung beabstandet Piezosubstrate 3 platziert, nachdem zuvor an den dafür vorgesehenen Bestückungsplätzen des Ausgangssubstrates 24 und/oder an der dem Ausgangssubstrat 24 zugewandten Unterseite der Piezosubstrate 3 der Klebstoff 5 aufgebracht worden ist. Der Klebstoff 5, der bei allen Ausführungsbeispielen zweckmäßigerweise ein thermisch aushärtender, anisotroper, unter Temperaturerhöhung niedrig viskoser Klebstoff ist, kann beispielsweise durch ein Bedruckverfahren oder durch sogenanntes Dispensen mit der gewünschten Schichtdicke aufgebracht werden. Dieses geschieht mittels einer beim Ausführungsbeispiel der Figuren 2 bis 4 nicht weiter abgebildeten Klebstoffauftragsvorrichtung.

Derart bestückt liegt ein Längsgestalt aufweisender Substratstrang 23 vor, dessen bandförmiges Ausgangssubstrat 24 mehrfach mit in seiner Längsrichtung nebeneinander angeordneten Piezosubstraten 3 bestückt ist.

Die auf diese Weise zusammenhängenden Substratbaugruppen 17 werden in dieser zusammenhängenden Form durch die Transporteinrichtung 16 in die Abgabestation 15 transportiert. Der Abgabestation 15 ist eine Vereinzelungseinrichtung 25 zugeordnet oder nachgeordnet, beispielsweise ein Laserschneidgerät, mit dessen Hilfe das mit den fest aufgeklebten Piezosubstraten 3 ankommende Ausgangssubstrat 24 schrittweise zwischen jeweils aufeinanderfolgenden Piezosubstraten 3 abgelängt wird, so dass letztlich individuelle Substratbaugruppen 17 vorliegen, deren Substrate 2, 3 fest miteinander verklebt sind.

Dass die Vorrichtung auch zur Umsetzung individueller Substratbaugruppen 17 ausgebildet sein kann, illustriert das Ausführungsbeispiel der Figuren 5 und 6. Dort werden der Fügestation 14 einerseits Trägersubstrate 2 und andererseits Piezosubstrate 3 in jeweils bereits vereinzelter Form zugeführt, was exemplarisch mittels zweier Zuführeinrichtungen 26 erfolgt, die beispielsweise als Bandförderer oder auf sonstige Art und Weise ausgestaltet sind. Alternativ kann auch unmittelbar in der Fügestation 14 oder in deren Bereich eine Vereinzelungseinrichtung vorgesehen sein, durch die aus jeweils einem zugrundeliegenden Ausgangssubstrat die Trägersubstrate 2 und/oder die Piezosubstrate 3 individualisiert werden, beispielsweise durch Laserschneiden, Stanzen oder dergleichen.

Auf diese Weise werden jedenfalls in der Fügestation 14 sowohl die Trägersubstrate 2 als auch die Piezosubstrate 3 individuell bereitgestellt. Als Bereitstellungseinrichtungen fungieren exemplarisch unmittelbar die Zuführeinrichtungen 26. Alternativ ist es auch möglich, Bereitstellungseinrichtungen in Form von Speichermagazinen vorzusehen, in denen die Substrate 2, 3 nach Substratart sortiert in gestapelter Form bereitgestellt werden.

Eine in der Fügestation 14 vorhandene Fügeeinrichtung 32 stellt mindestens eine und vorzugsweise mehrere selbstzentrierende Werkstückaufnahmen 33 zur Verfügung, deren Umrisse jeweils dem Umriss einer Substratbaugruppe 17 entsprechen. In diese Werkstückaufnahmen 33 sind mittels einer Umsetzeinrichtung 27 die jeweils eine Substratbaugruppe 17 bildenden Substratpaare 2, 3 positionsgenau geschichtet einlegbar. Die Umsetzeinrichtung 27 enthält hierfür einen oder mehrere Umsetzer, die jeweils nach Art einer sogenannten Pick-and-place-Einheit ein Substrat 2 oder 3 aus einer Bereitstellungseinrichtung 28 entnehmen und in eine Werkstückaufnahme 33 umsetzen. Die zugeordneten Umsetzbewegungen 34 sind durch Pfeile illustriert.

In die Werkstückaufnahmen 33 wird jeweils zuerst ein Trägersubstrat 2 eingelegt. Bevor anschließend das zugeordnete Piezosubstrat 3 aufgelegt wird, erfolgt mittels einer Klebstoffauftragsvorrichtung 34 ein Auftrag des Klebstoffes 5 auf die nach oben weisende Fläche des betreffenden Trägersubstrates 2. Die Klebstoffauftragsvorrichtung 34 ist beispielsweise ein Drucker oder ein Dispenser. Nachdem derart ein Klebstoff 5 insbesondere in Form einer Klebstoffschicht appliziert wurde, wird das zugehörige Piezosubstrat 3 aufgelegt.

Der Klebstoffauftrag könnte auch an anderer Stelle der Prozesskette stattfinden, beispielsweise im Bereich der Bereitstellungseinrichtungen 28. Abweichend vom Ausführungsbeispiel besteht auch die Möglichkeit, anstelle des Trägersubstrates 2 das Piezosubstrat 3 mit dem Klebstoff 5 zu versehen oder einen Klebstoff 5 an beiden Substraten 2, 3 zu applizieren.

Ausgehend von der Fügeeinrichtung 32 werden die individuell zusammengestellten Substratbaugruppen 17 einzeln mittels der Transporteinrichtung 16 ergriffen und in die Abgabestation 15 verbracht, wo sie beispielsweise an eine Abfördereinrichtung 35 abgegeben werden, die sie ihrer weiteren Bestimmung zuführt.

Während des Transportes von der Fügestation 14 in die Abgabestation 15 ist jede Substratbaugruppe 17 individuell von einer Magnetspanneinrichtung 18 der Transporteinrichtung 16 gespannt.

Die Transporteinrichtung 16 kann gemäß Ausführungsbeispiel der Figuren 2 bis 4 eine Mehrfachausstattung an Magnetspanneinrichtungen 18 aufweisen, durch die zeitgleich mehrere Substratbaugruppen 17 gespannt sind und zu der Abgabestation 15 transportiert werden. Bevorzugt wird hierbei ein Aufbau der Transporteinrichtung 16 mit im Betrieb eine kontinuierliche Umlaufbewegung ausführenden Magnetspanneinrichtungen 18, was eine sehr effektive und erschütterungsarme Prozessführung gestattet.

Exemplarisch enthält die Transporteinrichtung 16 hierfür zwei mit Abstand zueinander angeordnete Umlenkräder 36a, 36b, von denen eines drehangetrieben ist und um die ein Transportstrang 37 herumgeschlungen ist, der mit in der Umlaufrichtung 38 des Transportstranges 37 aufeinanderfolgend angeordneten Magnetspanneinrichtungen 18 ausgestattet ist.

Eines der beiden Trume des Transportstranges 37 durchläuft eine lineare Transportstrecke 42, entlang der sich auch der Substratstrang 23 bestehend aus dem Ausgangssubstrat 24 und den unter Zwischenfügung des Klebstoffes 5 darauf applizierten Piezosubstraten 3 erstreckt.

Im Bereich der Transportstrecke 42 liegen sich jeweils eine Substratbaugruppe 17 und eine Magnetspanneinrichtung 18 paarweise in der Schichtungsrichtung 4 gegenüber. Dabei ist an jeder in der Transportstrecke 42 befindlichen Magnetspanneinrichtung 18 eine der Substratbaugruppen 17 magnetisch gespannt.

Insbesondere wenn die Substratbaugruppen 17 bereits in der Fügestation 14 als individuelle Substratbaugruppen 17 zur Verfügung gestellt werden, können sie - wie dies in Figuren 5 und 6 illustriert ist - einzeln mittels einer nach Art einer Pick-and-place-Einheit arbeitenden Transporteinrichtung 16 zwischen der Fügestation 14 und der Abgabestation 15 umgesetzt werden. Exemplarisch verfügt die Transporteinrichtung 16 dabei über mindestens eine Umsetzeinheit 16a, die über mindestens eine und vorzugsweise über genau eine Magnetspanneinrichtung 18 verfügt und die alternierend hin und her bewegbar ist, um bei der einen Bewegungsphase die Transportbewegung 22 und bei einer entgegengesetzten Bewegungsphase eine Rückbewegung auszuführen.

Jede Magnetspanneinrichtung 18 ist zur Erzeugung der gewünschten, zum Festspannen und Verpressen einer Substratbaugruppe 17 verwendeten Magnetkraft individuell mit einer Elektromagneteinrichtung 44 ausgestattet. Selbige enthält zweckmäßigerweise unter anderem mindestens eine elektrisch bestrombare Spuleneinrichtung, die bei Stromdurchfluss ein Magnetfeld ausbildet. In der Spuleneinrichtung ist zweckmäßigerweise ein zur Verstärkung des Magnetfeldes beitragender Eisenkern angeordnet. Da der Aufbau von Elektromagneten als solches bekannt ist, wird an dieser Stelle auf die Erläuterung weiterer Details verzichtet.

Die Herstellungsvorrichtung 2a, 2b enthält eine nur schematisch angedeutete elektronische Steuereinrichtung 45, die eine selektive Bestromung beziehungsweise Aktivierung der Elektromagneteinrichtung 44 jeder Magnetspanneinrichtung 18 ermöglicht. Dementsprechend ist das Magnetfeld jeder Magnetspanneinrichtung 18 individuell erzeugbar und abschaltbar.

Exemplarisch enthält jede Magnetspanneinrichtung 18 einen bevorzugt als Gehäuse ausgebildeten Grundkörper 46, in den die zugehörige Elektromagneteinrichtung 44 insbesondere integriert ist.

Jede Magnetspanneinrichtung 18 verfügt des Weiteren über eine Abstützfläche 47. Die Abstützfläche 47 ist zweckmäßigerweise an dem Grundkörper 46 ausgebildet und so ausgerichtet, dass sie von der Elektromagneteinrichtung 44 abgewandt ist. Die Abstützfläche 47 befindet sich an einer Arbeitsseite 48 der Magnetspanneinrichtung 18, mit der voraus die Magnetspanneinrichtung 18 an die zu spannende und bevorzugt auch zu transportierende Substratbaugruppe 17 ansetzbar ist.

Die Herstellungsvorrichtung 2a, 2b verfügt über eine Spannzone 52, in der die noch unverklebten Substratbaugruppen 17 von jeweils einer Magnetspanneinrichtung 18 durch Magnetkraft erfasst und so festgehalten werden, dass ihre beiden Substrate 2, 3 durch die als Spannkraft wirkende Magnetkraft in der Schichtungsrichtung 4 fest zusammengepresst werden. Die Magnetkraft presst nicht nur die Substrate 2, 3 mit dem dazwischen befindlichen Klebstoff 5 zusammen, sondern hält die betreffende Substratbaugruppe 17 durch die Magnetkraft auch prozesssicher fest. Auf diese Weise können die Substratbaugruppen 17 beim zwecks Verkleben erfolgenden Zusammenpressen ihrer Substrate 2, 3 gleichzeitig auch zeitsparend zwischen verschiedenen Arbeitsstationen 10 verlagert werden, bei denen es sich exemplarisch um die Fügestation 14 und die Abgabestation 15 handelt.

Die zu verpressende Substratbaugruppe 17 wird der Magnetspanneinrichtung 18 in der Spannzone 52 in einer derartigen Ausrichtung zur Verfügung gestellt, dass das Piezosubstrat 3 in der Schichtungsrichtung 4 zwischen der Abstützfläche 47 und dem magnetischen Trägersubstrat 2 liegt. Diese Zuordnung ist in Figuren 2 und 6 gut ersichtlich. Beim anschließenden Aktivieren der Elektromagneteinrichtung 44 wird das Trägersubstrat 2 aufgrund seiner Wechselwirkung mit dem erzeugten Magnetfeld in Richtung der Abstützfläche 47 herangezogen. Bei diesem Vorgang stützt sich der Piezokörper 6 an der Abstützfläche 47 ab, was zur Folge hat, dass er zusammen mit dem Klebstoff 5 zwischen dem Trägersubstrat 2 und der Abstützfläche 47 mit einer durch die Magnetkraft bestimmten Prozesskraft eingespannt wird. Die Folge ist ein starkes gegenseitiges Verpressen der beiden Substrate 2, 3, so dass sich der zwischen den Substraten 2, 3 befindliche Klebstoff optimal großflächig verteilt und für einen sicheren Zusammenhalt der beiden Substrate 2, 3 nach seinem Aushärten sorgt.

Zum Verpressen der Substrate 2, 3 der Substratbaugruppe 17 wird dementsprechend auf nur einer Seite der Substratbaugruppe 17 eine mechanische Abstützfläche 47 benötigt. Auf der entgegengesetzten Seite der Substratbaugruppe 17 bedarf es keines Spannelementes. Das Trägersubstrat 2 bildet quasi selbst ein zum Verpressen der Substratbaugruppe 17 verwendetes Spannelement, das durch die von der Magnetspanneinrichtung 18 erzeugte Magnetkraft beaufschlagt wird.

Das Aufnehmen einer noch unverklebten Substratbaugruppe 17 geschieht zweckmäßigerweise derart, dass die Magnetspanneinrichtung 18 bei deaktivierter Elektromagneteinrichtung 44 mit ihrer Abstützfläche 47 voraus an die dem Trägersubstrat 2 abgewandte Fläche des Piezosubstrates 3 angesetzt wird, worauf die Elektromagneteinrichtung 44 aktiviert wird und dadurch das magnetische Trägersubstrat 2 angezogen wird. Das Piezosubstrat 3 und der Klebstoff 5 werden dabei zwischen der Abstützfläche 47 und dem Trägersubstrat 2 verspannt. Das hierbei wirkende Magnetfeld tritt dabei zweckmäßigerweise durch das Piezosubstrat 3 und den Klebstoff 5 hindurch.

Das Trägersubstrat 2 besteht zweckmäßigerweise aus einem nicht permanentmagnetischen Material, so dass eine durch den Einfluss des erzeugten Magnetfeldes hervorgerufene Magnetisierung des Trägersubstrates 2 nach Deaktivierung des Magnetfeldes entweder selbsttätig oder mittels eines einfachen nachfolgenden Prozessschrittes wieder aufhebbar ist. Bevorzugt besteht das Trägersubstrat 2 aus einem ferromagnetischen Material, insbesondere Stahl, so dass in einem dem Verpressen nachgeschalteten Prozessschritt durch Anlegen eines entgegengesetzt polarisierten Magnetfeldes problemlos eine Entmagnetisierung vorgenommen werden kann.

Zum Verkleben der beiden Substrate 2, 3 wird zweckmäßigerweise ein thermisch aushärtender Klebstoff 5 verwendet. In diesem Zusammenhang erfolgt das Verpressen der aufeinandergeschichteten Substrate 2, 3 der einzelnen Substratbaugruppen 17 vorzugsweise unter gleichzeitiger Wärmezufuhr.

Beide beispielhaften Herstellungsvorrichtungen 2a, 2b enthalten stilisiert angedeutete Heizmittel 53, mit deren Hilfe ein Wärmeeintrag in die Substratbaugruppen 17 möglich ist, um die Aushärtung des Klebstoffes 5 zu unterstützen.

Als besonders zweckmäßig wird es angesehen, wenn die Heizmittel 53 ein Aufheizen der jeweils an einer Magnetspanneinrichtung 18 festgehaltenen Substratbaugruppe 17 ermöglichen. Die Wärmezufuhr unmittelbar während des Vorganges des gegenseitigen Verpressens der Substrate 2, 3 wirkt sich vorteilhaft auf die Festigkeit des Klebeverbundes aus und bewirkt eine enorme Zeiteinsparung bei der Prozessabwicklung.

Eine als optimal angesehene Ausgestaltung der Herstellungsvorrichtungen 2a, 2b sieht vor, dass die Heizmittel 53 für jede Magnetspanneinrichtung 18 eine eigene Heizeinrichtung 54 enthalten, durch die die Magnetspanneinrichtung 18 aufheizbar ist, wobei sie ihre Wärme an die an ihre Abstützfläche 47 angepresste Substratbaugruppe 17 abgibt. Die notwendige Prozesswärme wird in die Substratbaugruppe 17 also zweckmäßigerweise unmittelbar aus der Magnetspanneinrichtung 18 eingeleitet. Wie in Figuren 2 und 6 schematisch illustriert ist, ist die Heizeinrichtung 54 insbesondere als Baueinheit mit der zugeordneten Magnetspanneinrichtung 18 ausgeführt und insbesondere in den Grundkörper 46 der Magnetspanneinrichtung 18 integriert.

Jede Heizeinrichtung 54 enthält zweckmäßigerweise mindestens eine Heizwendel. Alternativ oder zusätzlich können aber auch andere Wärmequellen vorgesehen sein. Als besonders vorteilhaft wird es angesehen, wenn die Abstützfläche 47 ein unmittelbarer Bestandteil einer Heizplatte ist, die ihre Wärme direkt in den an ihr anliegenden Piezokörper 6 einleitet.

Bei einer ausreichend langen Transportstrecke 42 genügen die den Magnetspanneinrichtungen 18 individuell direkt zugeordneten Heizeinrichtungen 54 für den benötigten Wärmeeintrag. Gleichwohl können die Heizmittel 53 zusätzlich noch eine oder mehrere externe Heizeinheiten 55 enthalten, durch die mindestens eine Heizstrecke definiert wird, an der die Substratbaugruppen 17 bei ihrem Transport zwischen verschiedenen Arbeitspositionen 10 vorbeibewegt werden.

Exemplarisch erstreckt sich beim Ausführungsbeispiel der Figuren 2 bis 4 längsseits neben dem Transportweg der die Transportstrecke 42 durchlaufenden Magnetspanneinrichtungen 18 eine erste Heizeinheit 55a, die kontinuierlich Strahlungs- und/oder Konvektionswärme an die sich vorbeibewegenden und an den Magnetspanneinrichtungen 18 fixierten Substratbaugruppen 17 abgibt. Diese erste Heizeinheit 55a erstreckt sich jedoch vorteilhafterweise auch noch über die Transportstrecke 42 hinaus, so dass sie auch dann noch auf die bereits verklebten Substratbaugruppen 17 einwirkt, wenn diese nicht mehr von einer Magnetspanneinrichtung 18 gehalten werden. Die erste Heizeinheit 55a hat also auch einen sich ausgangsseitig an die Transporteinrichtung 16 anschließenden Heizbereich.

In der gleichen sich an die Transporteinrichtung 16 anschließenden Zone kann eine zweite Heizeinheit 55b angeordnet sein, die der ersten Heizeinheit 55a quer zur Transportrichtung der Substratbaugruppen 17 gegenüberliegt, so dass die Substratbaugruppen 17 von entgegengesetzten Seiten her mit Temperatur beaufschlagt werden.

Wenn sich Heizmittel 53 auch im Anschluss an die Transporteinrichtung 16 befinden, kann die Transportstrecke 42 zu Gunsten kompakter Abmessungen der Vorrichtung reduziert werden, weil in der Regel bereits eine kurze Anhärtung des Klebstoffes 5 ausreicht, um die Substrate 2, 3 derart fest miteinander zu verkleben, dass sie für die sich an das Verpressen anschließenden Prozessschritte sicher gegenseitig fixiert sind. Es versteht sich, dass die Bereiche der Heizeinheiten 55, 55a, 55b, die sich an die Transportstrecke 42 anschließen, hinsichtlich der optimalen Restaushärtezeit des Klebstoffes 5 ausgelegt sind, so dass der Aushärteprozess ununterbrochen bis zum gewünschten Ende ausgeführt wird.

Beim Ausführungsbeispiel der Figuren 5 und 6 sind externe Heizelemente nicht illustriert, sie können jedoch ebenfalls vorhanden sein.

Solange eine Substratbaugruppe 17 an einer Magnetspanneinrichtung 18 magnetisch gespannt ist, unterliegen ihre Bestandteile einer Beaufschlagung durch Druck und Temperatur, was einen optimalen Klebevorgang verspricht.

Bei dem diskontinuierlichen Verfahrensablauf der Figuren 5 und 6 versteht es sich, dass die geschilderten Abläufe zeitlich parallel stattfinden können, so dass also beispielsweise die Bereitstellungseinrichtungen 26 wieder mit Substraten 2, 3 nachgefüllt werden, während noch im Bereich der Transporteinrichtung 16 ein Umsetzen und festes Verkleben der Substratbaugruppen 17 stattfindet.

Durch das Aufheizen der Substratbaugruppen 17 ergibt sich der weitere Vorteil, dass der für anschließende Kontaktierungsmaßnahmen zwecks Anbringung der elektrischen Leiter 12, 13 erforderliche Wärmeeintrag nur noch relativ gering ist. Die aufgewandte Energie ist also mehrfach nutzbar.

Bei der in Figuren 2 bis 4 illustrierten Herstellungsvorrichtung 2a wird die durch einen Pfeil illustrierte Vorschubbewegung 56 des Substratstranges 23 bevorzugt ausschließlich durch die Transporteinrichtung 16 hervorgerufen. Bei der Umlaufbewegung 38 des Transportstranges 37 wird der magnetisch von den Magnetspanneinrichtungen 18 festgehaltene Substratstrang 23 ohne weiteres mitgezogen. Es versteht sich, dass die Transportgeschwindigkeit an die benötigte Aushärtezeit des Klebstoffes 5 angepasst ist. Das Zu- und Abschalten der Magnetkraft erfolgt bezüglich der einzelnen Magnetspanneinrichtungen 18 positionsbezogen unter Kontrolle der elektronischen Steuereinrichtung 45, die über nicht weiter abgebildete Detektionsmittel verfügt.

Die insbesondere bei einem ferromagnetischen Trägersubstrat 2 im Rahmen des magnetischen Festspannens auftretende Magnetisierung kann für nachfolgende Prozesse unterstützend bei der Positionierung von Bauteilen herangezogen werden, beispielsweise bei einem sich anschließenden Kontaktierungsprozess. Insofern wird ein Entmagnetisierungsvorgang zweckmäßigerweise erst dann angeschlossen, wenn durch die Magnetisierung keine Prozessunterstützung mehr gewünscht ist.

Durch das ausschließlich magnetische Festhalten und gegenseitige Verpressen der Substrate 2, 3 können auch bei einer Serienproduktion konstante Spannkräfte gewährleistet werden, und zwar unabhängig von den Fertigungs- und Montagetoleranzen, denen die Substrate 2, 3 unterliegen. Mithin erübrigt sich eine aufwendige Regelung der Spannkraft. Dies ermöglicht einen kostengünstigen Aufbau der Herstellungsvorrichtungen 2a, 2b.

## Patentansprüche

1. Verfahren zur Herstellung von Piezowandlern, die jeweils in einer Schichtungsrichtung (4) aufeinandergeschichtete Substrate in Form eines magnetischen Trägersubstrates (2) und eines piezoelektrisch aktivierbaren Piezosubstrates (3) aufweisen, die mittels eines zwischen ihnen befindlichen Klebstoffes (5) aneinander befestigt sind, wobei die beiden Substrate (2, 3) nach zuvor auf mindestens einem der Substrate (2, 3) erfolgter Applikation von Klebstoff (5) unter Bildung einer Substratbaugruppe (17) aufeinandergeschichtet und in der Schichtungsrichtung (4) miteinander verspannt werden, **dadurch gekennzeichnet, dass** zum Verspannen der beiden Substrate (2, 3) das Piezosubstrat (3) abgestützt und das Trägersubstrat (2) durch elektromagnetisch erzeugte Magnetkraft an das abgestützte Piezosubstrat (3) angepresst wird.

2. Verfahren nach Anspruch 1, **dadurch gekennzeichnet, dass** zum Anpressen des Trägersubstrates (2) an das Piezosubstrat (3) eine ziehend wirkende Magnetkraft eingesetzt wird.

3. Verfahren nach Anspruch 2, **dadurch gekennzeichnet, dass** die ziehend wirkende Magnetkraft durch das Piezosubstrat (3) hindurch in das Trägersubstrat (2) eingeleitet wird.

4. Verfahren nach einem der Ansprüche 1 bis 3, **dadurch gekennzeichnet, dass** das Verspannen der beiden Substrate (2, 3) während eines Transportvorganges der Substratbaugruppe (17) stattfindet, insbesondere während eines Transportes von einer Fügestation (14), in der die Substratbaugruppe (17) zusammengesetzt wird, zu einer Abgabestation (15).

5. Verfahren nach einem der Ansprüche 1 bis 4, **dadurch gekennzeichnet, dass** als Trägersubstrat (2) ein mehrfach mit nebeneinander angeordneten Piezosubstraten (3) bestücktes und später durch Trennvorgänge zu den Trägersubstraten (2) vereinzelbares Ausgangssubstrat (24) verwendet wird.

6. Verfahren nach einem der Ansprüche 1 bis 5, **dadurch gekennzeichnet, dass** das Verpressen der aufeinandergeschichteten Substrate (2, 3) unter gleichzeitiger Wärmezufuhr stattfindet, insbesondere dadurch, dass eine die Substratbaugruppe (17) festhaltende Magnetspanneinrichtung (18) beheizt wird.

7. Verfahren nach einem der Ansprüche 1 bis 6, **dadurch gekennzeichnet, dass** der herzustellende Piezowandler (1) ein piezoelektrischer Biegewandler ist und/oder dass für das Trägersubstrat (2) ein ferromagnetisches Material verwendet wird.

8. Vorrichtung zur Herstellung von Piezowandlern, die jeweils in einer Schichtungsrichtung (4) aufeinandergeschichtete Substrate in Form eines magnetischen Trägersubstrates (2) und eines piezoelektrisch aktivierbaren Piezosubstrates (3) aufweisen, die mittels eines zwischen ihnen befindlichen Klebstoffes (5) aneinander befestigt sind, mit mindestens einer Spanneinrichtung, durch die die beiden nach vorheriger Applikation des Klebstoffes (5) zu einer Substratbaugruppe (17) aufeinandergeschichteten Substrate (2, 3) in der Schichtungsrichtung (4) miteinander verspannbar sind, **dadurch gekennzeichnet, dass** die Spanneinrichtung als elektromagnetische Magnetspanneinrichtung (18) ausgebildet ist, die eine Abstützfläche (47) zur Abstützung des Piezosubstrates (3) der zu verspannenden Substratbaugruppe (17) aufweist und durch die elektromagnetisch eine Magnetkraft erzeugbar ist, mittels der das Trägersubstrat (2) der an der Abstützfläche (47) abgestützten Substratbaugruppe (17) in Richtung der Abstützfläche (47) derart beaufschlagbar ist, dass es an das von der Abstützfläche (47) abgestützte Piezosubstrat (3) angepresst wird.

9. Vorrichtung nach Anspruch 8, **dadurch gekennzeichnet, dass** die Magnetspanneinrichtung (18) eine Elektromagneteinrichtung (44) aufweist, die insbesondere auf der der Abstützfläche (47) abgewandten Seite platziert ist, derart, dass die erzeugbare Magnetkraft das Trägersubstrat (2) der momentan zugeordneten Substratbaugruppe (17) in Richtung zu der Abstützfläche (47) ziehend beaufschlagt.

10. Vorrichtung nach Anspruch 8 oder 9, **dadurch gekennzeichnet, dass** die Magnetspanneinrichtung (18) Bestandteil einer Transporteinrichtung (16) ist, durch die die Magnetspanneinrichtung (18) unter gleichzeitigem Transport einer festgespannten Substratbaugruppe (17) zwischen verschiedenen Arbeitsstationen (10) transportierbar ist, insbesondere zwischen einer Fügestation (14), in der die Substratbaugruppe (17) zusammengesetzt wird, und einer Abgabestation (15).

11. Vorrichtung nach Anspruch 10, **dadurch gekennzeichnet, dass** die Transporteinrichtung (16) eine Mehrfachausstattung an Magnetspanneinrichtungen (18) aufweist, durch die simultan mehrere Substratbaugruppen (17) zwischen zwei Arbeitsstationen (10) transportierbar sind.

12. Vorrichtung nach Anspruch 10 oder 11, **dadurch gekennzeichnet, dass** die Transporteinrichtung (16) mit mindestens einer kontinuierlich umlaufenden oder mit mindestens einer alternierend hin und her bewegbaren Magnetspanneinrichtung (18) ausgestattet ist.

13. Vorrichtung nach einem der Ansprüche 8 bis 12, **dadurch gekennzeichnet, dass** sie über Heizmittel (53) zur Aufheizung der an der Magnetspanneinrichtung (18) gehaltenen Substratbaugruppe (17) verfügt.

14. Vorrichtung nach Anspruch 13, **dadurch gekennzeichnet, dass** die Heizmittel (53) eine jeder Magnetspanneinrichtung (18) unmittelbar individuell zugeordnete und insbesondere als Baueinheit mit der Magnetspanneinrichtung (18) ausgebildete Heizeinrichtung (54) enthalten.

15. Vorrichtung nach einem der Ansprüche 8 bis 14, **dadurch gekennzeichnet, dass** sie zur Durchführung des Verfahrens nach einem der Ansprüche 1 bis 7 verwendet wird.

## Claims

1. Method for producing piezoelectric transducers, each of which comprises substrates in the form of a magnetic carrier substrate (2) and a piezoelectrically activatable piezoelectric substrate (3), which are layered on top of one another in a layering direction (4) and which are secured to one another by means of an adhesive (5) placed in between, wherein the two substrates (2, 3), following the application of adhesive (5) to at least one of the substrates (2, 3), are layered on top of one another to form a substrate assembly (17) and clamped to one another in the layering direction (4), **characterised in that**, for clamping the two substrates (2, 3), the piezoelectric substrate (3) is supported and the carrier substrate (2) is pressed onto the supported piezoelectric substrate (3) by a magnetic force generated by electromagnetic means.

2. Method according to claim 1, **characterised in that** an attracting magnetic force is used to press the carrier substrate (2) onto the piezoelectric substrate (3).

3. Method according to claim 2, **characterised in that** the attracting magnetic force is introduced into the carrier substrate (2) through the piezoelectric substrate (3).

4. Method according to any of claims 1 to 3, **characterised in that** the two substrates (2, 3) are clamped to one another while the substrate assembly (17) is being conveyed, in particular while it is being conveyed from a joining station (14), where the substrate assembly (17) is assembled, to a delivery station (15).

5. Method according to any of claims 1 to 4, **characterised in that** a starting substrate (24) which is equipped with multiple piezoelectric substrates (3) arranged adjacent to one another and which can subsequently be segregated in separating processes to form the carrier substrates (3) is used as a carrier substrate (3).

6. Method according to any of claims 1 to 5, **characterised in that** the pressing together of the layered substrates (2, 3) is carried out under simultaneous heat input, in particular by heating a magnetic clamping device (18) which holds the substrate assembly (17).

7. Method according to any of claims 1 to 6, **characterised in that** the piezoelectric transducer (1) to be produced is a piezoelectric bending transducer, and/or **in that** a ferromagnetic material is used for the carrier substrate (2).

8. Device for producing piezoelectric transducers, each of which comprises substrates in the form of a magnetic carrier substrate (2) and a piezoelectrically activatable piezoelectric substrate (3), which are layered on top of one another in a layering direction (4) and which are secured to one another by means of an adhesive (5) placed in between, comprising at least one clamping device by means of which the two substrates (2, 3), which are layered on top of one another to form a substrate assembly (17) following the application of the adhesive (5), can be clamped to one another in the layering direction (4), **characterised in that** the clamping device is designed as an electromagnetic magnetic clamping device (18) which has a supporting surface (47) for supporting the piezoelectric substrate (3) of the substrate assembly (17) to be clamped and by which a magnetic force can be generated electromagnetically, which force can be applied to the carrier substrate (2) of the substrate assembly (17) supported on the supporting surface (47) in the direction of the supporting surface (47) in such a way that the carrier substrate (2) is pressed onto the piezoelectric substrate (3) supported on the supporting surface (47).

9. Device according to claim 8, **characterised in that** the magnetic clamping device (18) comprises a solenoid device (44) which is in particular placed on the side remote from the supporting surface (47) in such a way that the magnetic force which can be generated attracts the carrier substrate (2) of the currently associated substrate assembly (17) in the direction towards the supporting surface (47).

10. Device according to claim 8 or 9, **characterised in that** the magnetic clamping device (18) is a part of a conveying device (16) through which the magnetic clamping device (18) can be conveyed together with a clamped substrate assembly (17) between various working stations (10), in particular between joining station (14), where the substrate assembly (17) is assembled, and a delivery station (15).

11. Device according to claim 10, **characterised in that** the conveying device (16) is multiply equipped with magnetic clamping devices (18) by which a plurality of substrate assemblies (17) can be conveyed simultaneously between two working stations (10).

12. Device according to claim 10 or 11, **characterised in that** the conveying device (16) is equipped with at least one continuously running magnetic clamping device (18) or with at least one magnetic clamping device (18) capable of alternating reciprocating movement.

13. Device according to any of claims 8 to 12, **characterised in that** it comprises heating means (53) for heating the substrate assembly held on the magnetic clamping device (18).

14. Device according to claim 13, **characterised in that** the heating means (53) comprise heating devices (54) directly and individually assigned to each magnetic clamping device (18) and in particular designed to form a unit with the magnetic clamping device (18).

15. Device according to any of claims 8 to 14, **characterised in that** it is used to carry out the method according to any of claims 1 to 7.

## Revendications

1. Procédé servant à fabriquer des transducteurs piézoélectriques, lesquels présentent respectivement des substrats empilés les uns sur les autres dans une direction d'empilage (4), lesdits substrats se présentant sous la forme d'un substrat de support (2) magnétique et d'un substrat piézoélectrique (3) pouvant être activé de manière piézoélectrique, lesquels sont fixés les uns aux autres au moyen d'une substance adhésive (5) se trouvant entre eux, sachant que les deux substrats (2, 3) sont empilés après l'application préalable de substance adhésive (5) sur au moins un des substrats (2, 3) en formant un ensemble de substrats (17) et sont serrés l'un contre l'autre dans la direction d'empilage (4), **caractérisé en ce que** le substrat piézoélectrique (3) est en appui pour serrer les deux substrats (2, 3), et **en ce que** le substrat de support (2) est pressé contre le substrat piézoélectrique (3) en appui par une force magnétique générée de manière électromagnétique.

2. Procédé selon la revendication 1, **caractérisé en ce qu'**une force magnétique ayant une action de traction est utilisée pour presser le substrat de support (2) contre le substrat piézoélectrique (3).

3. Procédé selon la revendication 2, **caractérisé en ce que** la force magnétique ayant une action de traction est introduite en passant par le substrat piézoélectrique (3) dans le substrat de support (2).

4. Procédé selon l'une quelconque des revendications 1 à 3, **caractérisé en ce que** le serrage des deux substrats (2, 3) a lieu au cours d'une opération de transport de l'ensemble de substrats (17), en particulier au cours d'un transport partant d'un poste d'assemblage (14), dans lequel l'ensemble de subtrats (17) est assemblé, en direction d'un poste de distribution (15).

5. Procédé selon l'une quelconque des revendications 1 à 4, **caractérisé en ce qu'**on utilise comme substrat de support (2), un substrat de sortie (24) doté de manière multiple de substrats piézoélectriques (3) disposés les uns à côté des autres et pouvant être séparé ultérieurement par des opérations de séparation afin d'obtenir des substrats de support (2).

6. Procédé selon l'une quelconque des revendications 1 à 5, **caractérisé en ce que** l'action de comprimer les substrats (2, 3) empilés les uns sur les autres se fait par apport simultané de chaleur, en particulier **en ce qu'**un système de serrage magnétique (18) maintenant l'ensemble de substrats (17) est chauffé.

7. Procédé selon l'une quelconque des revendications 1 à 6, **caractérisé en ce que** le transducteur piézoélectrique (1) devant être fabriqué est un transducteur de flexion piézoélectrique, et/ou **en ce qu'**on utilise pour le substrat de support (2) un matériau ferromagnétique.

8. Dispositif servant à fabriquer des transducteurs piézoélectriques, qui présentent respectivement des substrats empilés les uns sur les autres dans une direction d'empilage (4), lesdits substrats se présentant sous la forme d'un substrat de support (2) magnétique et d'un substrat piézoélectrique (3) pouvant être activé de manière piézoélectrique, lesquels sont fixés les uns aux autres au moyen d'une substance adhésive (5) se trouvant entre eux, comprenant au moins un système de serrage, lequel permet de serrer l'un à l'autre les deux substrats (2, 3) dans la direction d'empilage (4) empilés les uns sur les autres après l'application préalable de la substance adhésive (5) pour former un ensemble de substrats (17), **caractérisé en ce que** le système de serrage est réalisé sous la forme d'un système de serrage magnétique (18) électromagnétique, lequel présente une surface d'appui (47) servant à l'appui du substrat piézoélectrique (3) de l'ensemble de substrats (17) devant être serré et qui permet de générer de manière électromagnétique une force magnétique, au moyen de laquelle le substrat de support (2) de l'ensemble de substrats (17) en appui au niveau de la surface d'appui (47) peut être sollicité en direction de la surface d'appui (47) de telle manière qu'il est pressé contre le substrat piézoélectrique (3) en appui au niveau de la surface d'appui (47).

9. Dispositif selon la revendication 8, **caractérisé en ce que** le système de serrage magnétique (18) présente un système électromagnétique (44), qui est placé en particulier sur le côté opposé à la surface d'appui (47) de telle manière que la force magnétique générée soumet le substrat de support (2) de l'ensemble de substrats (17) momentanément associé, en direction de la surface d'appui (47), à l'action d'une traction.

10. Dispositif selon la revendication 8 ou 9, **caractérisé en ce que** le système de serrage magnétique (18) fait partie intégrante d'un système de transport (16), lequel permet de transporter le système de serrage magnétique (18) tout en transportant simultanément un ensemble de substrats (17) bloqué par serrage entre divers postes de travail (10), en particulier entre un poste d'assemblage (14), dans lequel l'ensemble de substrats (17) est assemblé, et un poste de distribution (15).

11. Dispositif selon la revendication 10, **caractérisé en ce que** le système de transport (16) présente un équipement multiple en termes de systèmes de serrage magnétique (18), lesquels permettent de transporter de manière simultanée plusieurs ensembles de substrats (17) entre deux postes de travail (10).

12. Dispositif selon la revendication 10 ou 11, **caractérisé en ce que** le système de transport (16) est équipé d'au moins un système de serrage magnétique en rotation en continu ou d'au moins un système de serrage magnétique (18) effectuant en alternance des mouvements de va-et-vient.

13. Dispositif selon l'une quelconque des revendications 8 à 12, **caractérisé en ce qu'**il dispose de moyens de chauffage (53) servant à chauffer l'ensemble de substrats (17) maintenu au niveau du système de serrage magnétique (18).

14. Dispositif selon la revendication 13, **caractérisé en ce que** les moyens de chauffage (53) contiennent un système de chauffage (54) directement associé individuellement à chaque système de serrage magnétique (18) et réalisé en particulier sous la forme d'une unité structurelle avec le système de serrage magnétique (18).

15. Dispositif selon l'une quelconque des revendications 8 à 14, **caractérisé en ce qu'**on utilise ledit dispositif aux fins de la mise en oeuvre du procédé selon l'une quelconque des revendications 1 à 7.
